# EUROPÄISCHE PATENTSCHRIFT

(11) **EP 0 766 287 B1**
(45) Veröffentlichungstag und Bekanntmachung des Hinweises auf die Patenterteilung: **22.08.2001**
(21) Anmeldenummer: 96107816.9
(22) Anmeldetag: 15.05.1996
(51) Int. Cl.: H01L 21/00

(54) **Indexer für Magazinfächer eines Magazins und darin enthaltene scheibenförmige Objekte**
Indexing of a container compartment with the contained disk-like substrate
Indexation des compartiments d'un conteneur et du substrat en forme de disque qui y est contenu

(30) Priorität: 27.09.1995 DE 19535871
(43) Veröffentlichungstag der Anmeldung: 02.04.1997
(73) Patentinhaber: JENOPTIK Aktiengesellschaft, 07743 Jena (DE)
(72) Erfinder: Schlehahn, Volker, 07747 Jena (DE); Schultz, Klaus, 07745 Jena (DE)
(74) Vertreter: Geyer, Werner, Dr.-Ing.

(56) Entgegenhaltungen:
- DE-C- 4 306 957
- US-A- 5 452 078

## Beschreibung

Die Erfindung betrifft einen Indexer für Magazinfächer eines Magazins und darin enthaltene scheibenförmige Objekte, insbesondere Halbleiterscheiben und Schablonen, zu deren Bearbeitung das Magazin und eine erste Handhabungsebene zur Entnahme und Beschickung der Objekte im Magazin relativ zueinander vertikal verstellbar sind, mit einer optoelektronischen Sensoranordnung zum Erfassen der vertikalen Lage der Objekte im Magazin und der Magazinfächer relativ zu einer Bezugsebene, die mit der ersten Handhabungsebene in fester Beziehung steht und parallel zu dieser liegt.

Derartige technische Lösungen sind bei der Herstellung integrierter Schaltkreise, insbesondere für Handhabungsaufgaben, anwendbar und beispielsweise aus der DE 43 06 957 C1 bekannt.

Bei der Herstellung integrierter Schaltkreise müssen scheibenförmige Objekte, wie Halbleiterscheiben und Schablonen, zwischen unterschiedlichen Bearbeitungsschritten zu einzelnen Bearbeitungsmaschinen transportiert werden. In zunehmendem Maße geschieht dies in standardisierten Transportbehältern, sogenannten Standard Mechanical Inter Face Boxen (SMIF-Boxen), auf deren Boden das Magazin, in dessen Fächern sich die scheibenförmigen Objekte befinden, in geeigneter Weise fixiert ist.

Zur Beschickung der Bearbeitungsmaschinen werden die Magazine aus den Transportbehältern mit geeigneten Mitteln entladen und die scheibenförmigen Objekte mit einer Entnahme- und Beschickungsvorrichtung entnommen. Nach der Bearbeitung erfolgt sowohl deren Rückführung in die Fächer des Magazins als auch die des Magazins in den Transportbehälter.

Ein möglicher Einsatz von Staudrucksensoren oder Reflexkopplern, die bei der Detektion auf die Rückseite der scheibenförmigen Objekte wirken, besitzt den Nachteil, daß die Abarbeitung des Magazins in einer bestimmten Reihenfolge erfolgen muß. Dabei können die Objekte nicht wahlfrei aus dem Magazin entnommen werden, sondern das Beschickungsmagazin muß von unten nach oben geleert und das Ausgabemagazin muß von oben nach unten gefüllt werden, bedingt durch die erforderliche Sensoranordnung und die damit verbundene Entnahme bzw. Zuführung der Objekte. Dadurch bleibt die Objektzuordnung zu einer bestimmten Etage nicht erhalten.

Sowohl bei der Inspektion übliche Stichprobenentnahmen als auch ein Einsatz in den bereits genannten Transportbehältern sind mit derartigen technischen Lösungen nicht möglich.

Aus der US-Patentschrift 4 895 486 ist es bekannt mit einem Kontrollgerät die Anwesenheit scheibenförmiger Objekte in einem Träger (Magazin) und deren relative Lage zu einer Bezugsebene in dem Träger zu bestimmen, indem ein erstes Signal für die Anwesenheit eines derartigen Objektes und ein Ortssignal für das Objekt miteinander verknüpft werden.
Das erste Signal wird durch einen optoelektronischen Sensor gewonnen, der den Raum, in dem sich die Objekte befinden können, überwacht. Das zweite Signal entsteht über einen mit einem Antrieb zum Auf- und Abfahren des Trägers gekoppelten Positionsencoder.
Zur Bestimmung der Bezugsebene und des möglichen Aufenthaltsraumes der Objekte wird der Raum im Träger vertikal in Segmente aufgeteilt. Neben einem als Bezugsebene dienenden Segment und Segmenten ohne scheibenförmige Objekte werden Window-Segmente definiert, in denen Objekte vorhanden sein können.
Es erfolgt eine Indexierung des Trägers, indem nach einer meßtechnischen Erfassung der Bezugsebene in dem Träger die Orte der Window-Segmente rechnerisch über die Konstruktionsdaten des jeweils verwendeten Trägers ermittelt und gespeichert werden.

Mit der beschriebenen Lösung kann zwar die Anzahl der Objekte und deren Ablageorte relativ zu einer Bezugsebene innerhalb des Trägers bestimmt werden. Jedoch ist zur Entnahme der Objekte aus dem Träger dieser oder die Entnahme- und Beschickungsvorrichtung im Rastermaß der Fächer des Trägers zu positionieren. Voneinander abweichende Trägergeometrien und Toleranzen müssen dabei berücksichtigt werden oder Fehler sind nicht auszuschließen. Probleme treten besonders dann auf, wenn ein leerer Träger beliebig beschickt werden soll.

Es ist außerdem möglich, durch einen weiteren optoelektronischen Sensor die richtige Lage des Objektes im Träger bei dessen Transport in vertikaler Aufwärtsrichtung zu kontrollieren. Damit soll verhindert werden, daß aus dem Träger herausragende Objekte bei der Rückführung in den Transportbehälter beschädigt werden. Wird ein aus dem Träger herausragendes Objekt, hervorgerufen durch ein fehlerhaftes oder nicht korrekt arbeitendes Handhabungssysten, erkannt, wird der Transport des Magazins gestoppt und es wird ein manueller Eingriff des Operators zur Fehlerbeseitigung erforderlich.

Das Erkennen herausragender Objekte ist zwar sinnvoll, der notwendige manuelle Eingriff verzögert jedoch unnötig jede Weiterbearbeitung mit Störungen der Reinraum- und unter Umständen der Klimabedingungen der Bearbeitungsmaschine innerhalb der Maschineneinhausung. Die Folge kann der Ausfall der Maschine sein.

Die in der Patentschrift DE 43 06 957 C1 beschriebene Lösung erfüllt alle die genannten Forderungen, indem durch ein Meßstrahlenbündel eines aus Sender und Empfänger bestehenden optoelektronischen Sensors neben der Lage der scheibenförmigen Objekte auch die Lage der Magazinfächer relativ zu einer Bezugsebene erfaßt wird. Die Bezugsebene steht konstruktiv mit einer Handhabungsebene zur Entnahme und Beschickung in fester Beziehung. Das Magazin ist mittels einer Magazinaufnahme durch einen Magazinlift meßbar in der Höhe zur Entnahme und Beschickung verstellbar.

Ein Nachteil besteht in der Beschränkung auf Magazine, bei denen zwei gegenüberliegende Seiten frei zugänglich sein müssen. Für Magazine, die nur an der zur Entnahme und Beschickung dienenden Seite offen sind, ist diese Einrichtung zur Indexierung nicht anwendbar. Ein weiterer Nachteil besteht darin, daß eine Unterscheidung verschiedener Magazinformate nicht unmittelbar möglich ist.

Es besteht deshalb die Aufgabe, durch eine universeller arbeitende Indexierung auch für Magazine, die nur an einer Seite zur Entnahme und Beschickung mit einer Öffnung versehen sind, einen genauen Zugriff in jede beliebige und vorherbestimmbare Magazinebene zu gewährleisten, wobei eine Unterscheidung von verschiedenen standardisierten Magazin- und Scheibenformaten möglich sein soll.

Erfindungsgemäß wird die Aufgabe bei einem Indexer für Magazinfächer eines Magazins und darin enthaltene scheibenförmige Objekte der eingangs genannten Art dadurch gelöst, daß die optoelektronische Sensoranordnung ein Abstandsmeßsystem zur Messung des Abstands der Sensoranordnung vom Rand der scheibenförmigen Objekte sowie von fächerbildenden Vorsprüngen des Magazins aufweist.

Sind die scheibenförmigen Objekte stirnseitig von Kante zu Kante lichtundurchlässig, so kann die gesamte Sensoranordnung als Abstandsmeßsystem aufgebaut sein, das an den Kanten der Objekte und Magazinfächer gestreute Strahlung erfaßt.

Das Abstandsmeßsystem enthält in einem solchen Fall, an einer offenen Seite des Magazins angeordnet, einen Sender und einen Empfänger, so daß ein von dem Sender ausgehendes, mit seinem Mittenstrahl in der Bezugsebene liegendes Meßstrahlenbündel durch die Vertikalverstellung des Magazins relativ zur Bezugsebene nacheinander die scheibenförmigen Objekte und fächerbildende Vorsprünge für die Objekte erfaßt, wobei die Unterscheidung zwischen den Objekten und den Vorsprüngen durch unterschiedliche Abstände zum Sender erfolgt.

Durch die Vertikalverstellung erfolgt eine Erzeugung eines Abbildes sowohl der Magazinfächer als auch der in den Magazinfächern befindlichen scheibenförmigen Objekte durch eine Amplitudenmodulation des Ausgangssignales, hervorgerufen durch die Änderung der Entfernung zwischen Sender und reflektierendem Gegenstand in der senkrecht zur Bewegungsrichtung liegenden Bezugsebene.
Mit Hilfe eines elektronischen Verstärkers wird das empfangene Signal, das in seiner Größe von der Entfernung zwischen Sender und Auftreffort abhängt, in ein Analogsignal umgewandelt.

Mit dem Sensorsystem, dessen Meßstrahlenbündel in einer waagerechten Ebene liegt, erfolgt sowohl eine vertikale Positionsbestimmung als auch durch Ermittlung der Koordinate in der waagerechten Ebene die Unterscheidung, ob der Gegenstand ein Magazinfach für ein scheibenförmiges Objekt oder das Objekt selbst ist.

Bei scheibenförmigen Objekten, die stirnseitig von Kante zu Kante lichtdurchlässig sind, ist eine Messung des rückwärtig gestreuten Lichtes nur bedingt möglich.

Deshalb ist es von Vorteil, wenn die optoelektronische Sensoranordnung aus einem Abstandsmeßsystem, das an einer offenen Seite des Magazins in der Bezugsebene angeordnet, einen Sender und einen Empfänger enthält und einem an der gegenüberliegenden offenen Seite des Magazins angeordneten weiteren Empfänger besteht. Ein von dem Sender ausgehendes Meßstrahlenbündel ist in der Bezugsebene geneigt zum senkrechten Strahlungseinfall auf die Objekte und Vorsprünge gerichtet.
Während das Abstandsmeßsystem zur Erfassung fächerbildender Vorsprünge dient, kann durch die Anordnung des weiteren Empfängers ein durch ein vorhandenes Objekt hervorgerufener Planplatteneffekt zum Nachweis des Objektes ausgenutzt werden.
Der weitere Empfänger kann entweder an dem Ort plaziert werden, auf den das Meßstrahlenbündel trifft, wenn sich kein Objekt im Magazinfach befindet oder an dem Ort, auf den das durch ein vorhandenes Objekt versetzte Meßstrahlenbündel fällt.

Für stirnseitig von Kante zu Kante lichtdurchlässige Objekte ist auch eine Sensoranordnung geeignet, die aus einem Abstandsmeßsystem, das an einer offenen Seite des Magazins angeordnet, einen Sender und einen Empfänger enthält, aus einem weiteren Sender auf derselben Seite und einem weiteren, an der gegenüberliegenden offenen Seite des Magazins angeordneten weiteren Empfänger besteht.
Bei dieser Sensoranordnung ist bevorzugt ein von dem weiteren Sender ausgehendes Meßstrahlenbündel in der Bezugsebene geneigt zum senkrechten Strahlungseinfall nur auf die Objekte gerichtet.
Das Abstandsmeßsystem dient zur Erfassung fächerbildender Vorsprünge. Der weitere Empfänger wird in der bereits beschriebenen Weise eingesetzt.

Vorteilhafterweise sind der Empfänger und der Sender des Abstandsmeßsystems in einer Baueinheit zusammengefaßt.

Mit der erfindungsgemäßen technischen Lösung werden die tatsächlich gegebenen Verhältnisse in einem zu indexierenden Magazin durch meßtechnische Erfassung der Magazinfächer und der darin enthaltenen scheibenförmigen Objekte ermittelt. Dadurch sind Entnahme und Rückführung beliebig ausführbar, wodurch Umsortierungen in jeder Art und Weise, auch zwischen Magazinen mit unterschiedlichem Fächerabstand, sowohl untereinander als auch zu einer Bezugsebene innerhalb des Magazins möglich werden. Auch leere Magazine können beliebig gefüllt werden. Die technische Lösung erlaubt auch den Einsatz von Magazinen oder magazinähnlichen Behältern, die mit Ausnahme der Beschickungs- und Entnahmeöffnung allseitig geschlossen sind.

Bei entsprechender Gestaltung des Magazines, wie das derzeit durch weltweiten Standard häufig gewährleistet ist, können unterschiedliche Magazinformate allein durch die Größe des Analogsignales bestimmt werden.
Auch die Bewertung der Lage des scheibenförmigen Objektes anhand der durch den Abstand bestimmten Größe des Analogsignales in jeder Ebene parallel zur Bezugsebene ist möglich und kann zur Unterscheidung der Scheibengröße oder zur Kontrolle der ortsgetreuen Ablage des scheibenförmigen Objektes im Anschluß an einen Handhabungsvorgang oder auch vor dessen Beginn herangezogen werden.

Liegt eine solche ortsgetreue Ablage nicht vor, ist es von Vorteil, wenn zur Positionierung aus dem Magazin herausragender scheibenförmiger Objekte eine Rückführeinrichtung in einer zweiten Handhabungsebene parallel zur ersten Handhabungsebene vorgesehen ist. Das Wirksamwerden der Rückführeinrichtung ist bei scheibenförmigen Objekten, die stirnseitig von Kante zu Kante lichtundurchlässig sind, an die Größe des Sensorsignals des Abstandsmeßsystems gebunden.
Bei vorhandener Lichtdurchlässigkeit kann ein weiteres Sensorsystem eingesetzt werden, das aus dem Magazin herausragende Objekte erkennt.
Die Rückführeinrichtung führt, ausgelöst durch das Sensorsignal, das Objekt ohne äußere Eingriffe in das Magazinfach zurück. Ohne einen manuellen Eingriff wird ein Weitertransport des Magazins in den Transportbehälter gewährleistet und eine Beschädigung herausragender Objekte vermieden.

Die Erfindung soll nachstehend anhand der schematischen Zeichnung näher erläutert werden. Es zeigen:
- Fig. 1: einen Teil einer Handhabungseinrichtung, teilweise im Schnitt;
- Fig. 2: eine Sensoranordnung für ein Wafermagazin;
- Fig. 3: eine erste Sensoranordnung für ein Schablonenmagazin;
- Fig. 4: anhand eines 5"- Schablonenmagazins eine zweite Sensoranordnung für ein Schablonenmagazin in einem Schnitt durch ein Magazin in der Ebene eines Magazinfaches mit einer Schablone unterhalb von fächerbildenden Vorsprüngen;
- Fig. 5: anhand eines 6"- Schablonenmagazins eine dritte Sensoranordnung für ein Schablonenmagazin in einem Schnitt durch ein Magazin in der Ebene eines Magazinfaches mit einer Schablone unterhalb von fächerbildenden Vorsprüngen;
- Fig. 6: einen Wandausschnitt aus einem Magazin für Objekte eines ersten kleineren Formates;
- Fig. 7: einen Wandausschnitt aus einem Magazin für Objekte eines zweiten größeren Formates;
- Fig. 8: die Wandabschnitte der Figuren 4a und 4b übereinanderprojiziert zusammen mit dazugehörigen optoelektronischen Abtastbildern, und
- Fig. 9: eine Draufsicht auf das Magazin mit einer Waferrückführeinrichtung

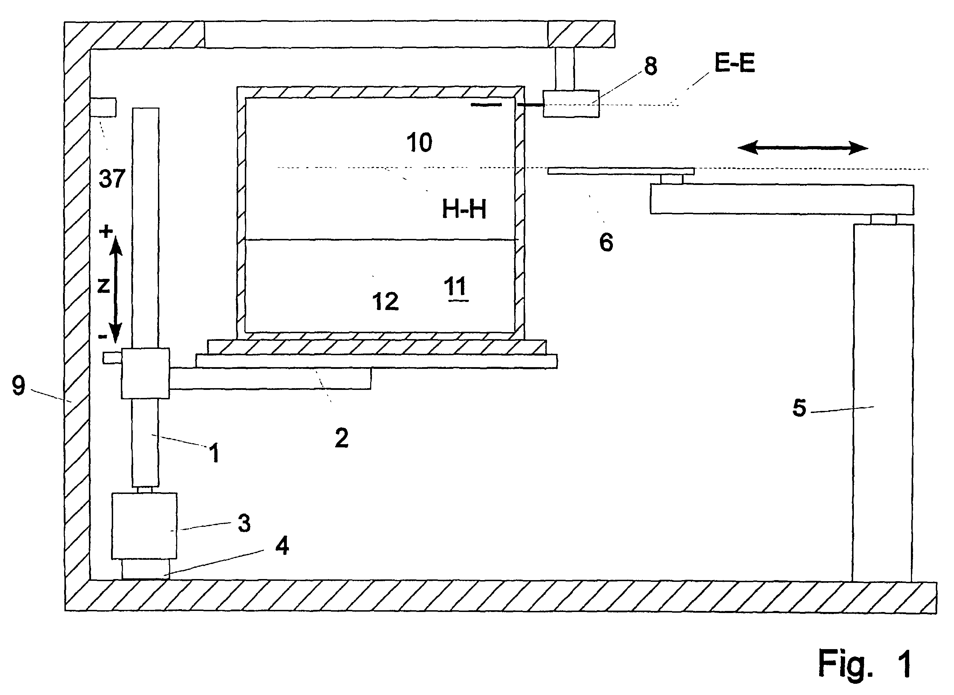

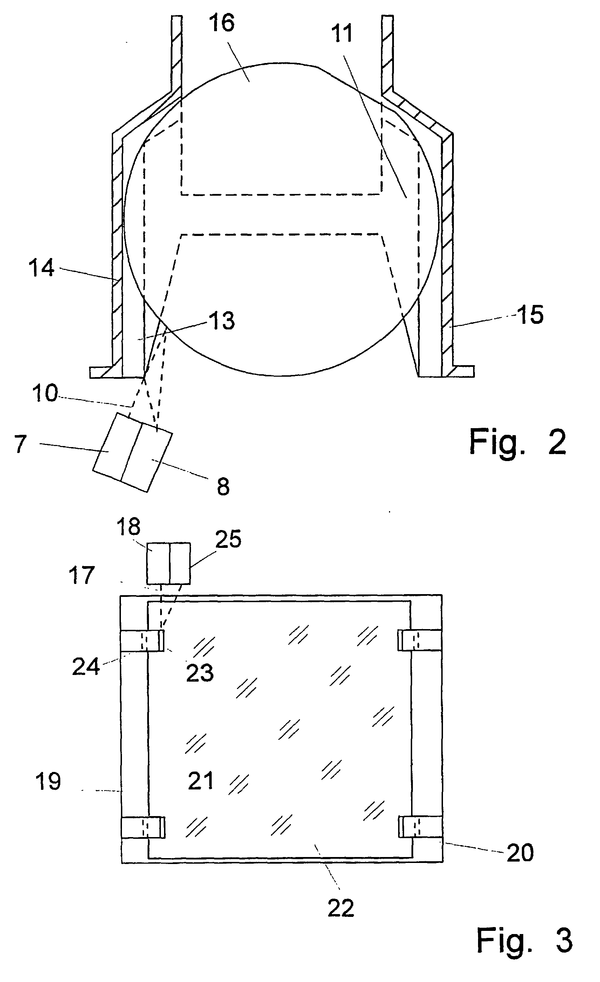

Eine Vorrichtung zur Handhabung scheibenförmiger Objekte, von der in Fig. 1 lediglich ein Teil dargestellt ist, besitzt in ihrem Inneren eine über einen Spindelantrieb 1 in z-Richtung (senkrecht zur Aufstellfläche der Handhabungseinrichtung) anheb- und absenkbare Magazinaufnahme 2. Der Antrieb der Spindel 1 erfolgt mit Hilfe eines Schrittmotors 3, der mit einem Winkelmeßsystem 4 ausgerüstet ist, so daß über die Spindelsteigung der zurückgelegte Weg beim Anheben oder Absenken ermittelt werden kann.
Der Schrittmotor 3 mit seiner Ansteuerelektronik und das Winkelmeßsystem 4 bilden gemeinsam mit einem nicht dargestellten Steuerrechner einen Positionsregler eines Magazinlifts, zu dem außerdem die Spindel 1 und die Magazinaufnahme 2 gehören.
Eine Entnahme- und Beschickungsvorrichtung 5 besitzt einen in einer Handhabungsebene H-H arbeitenden Handhabungsarm 6 und ist, wie der Magazinlift und ein optoelektronischer Sensor, der in einem Gehäuse einen Sender 7 (sichtbar in Fig. 2) und einen Empfänger 8 enthält, an einem gemeinsamen Rahmen 9 befestigt. Ein von dem Sender 7 ausgehendes Meßstrahlenbündel 10 verläuft mit seinem Mittenstrahl in einer Bezugsebene E-E zur Indexierung von in einem Magazin 11 befindlichen Magazinfächern und darin enthaltenen scheibenförmigen Objekten 12.
Der Abstand zwischen der Bezugsebene E-E und der Handhabungsebene H-H ist innerhalb des Fahrbereiches des Spindelantriebes 1 wählbar.

In Fig. 2 sind der Sender 7 und der Empfänger 8 nebeneinander angeordnet Das Meßstrahlenbündel 10 ist auf fächerbildende Vorsprünge 13 an Wänden 14 und 15 und den stirnseitigen Rand eingeschobener Halbleiterscheiben 16 als scheibenförmige Objekte gerichtet.
Durch diffuse Reflexion des Strahlenbündels 10 entweder an einem der Vorsprünge 13 oder dem stirnseitigen Rand einer eingeschobenen Halbleiterscheibe 16 werden den Abständen entsprechende Analogsignale erzeugt.
Diese Analogsignale unterscheiden sich in ihrer Größe derart, daß die Vorsprünge 13 von den Halbleiterscheiben 16 eindeutig unterschieden werden können.
Die dargestellte schräge Einstrahlung in das Magazin 11 wurde gewählt, um günstige Bedingungen für eine diffuse Reflexion zu schaffen.

Bei dem in Fig. 3 dargestellten Schablonenmagazin ist ein Meßstrahlenbündel 17 eines Senders 18 parallel zu Wänden 19, 20 auf fächerbildende Vorsprünge 21 und eventuell gleichzeitig auf in den Fächern befindliche Schablonen 22 gerichtet. Die Schablonen liegen auf Auflagen 23 der Vorsprünge 21 und sind durch seitliche Anschläge 24 gegen ein Verrutschen gesichert.
Durch den unterschiedlichen Abstand zwischen dem Sender 18 und dem Vorsprung 21 einerseits und dem Sender 18 und der Schablone 22 andererseits erhält man auch bei einem Schablonenmagazin an einem Empfänger 25 Analogsignale unterschiedlicher Größe. Aus der Größe des Analogsignales kann die Unterscheidung zwischen dem Vorsprung 21 und der Schablone 22 getroffen werden.

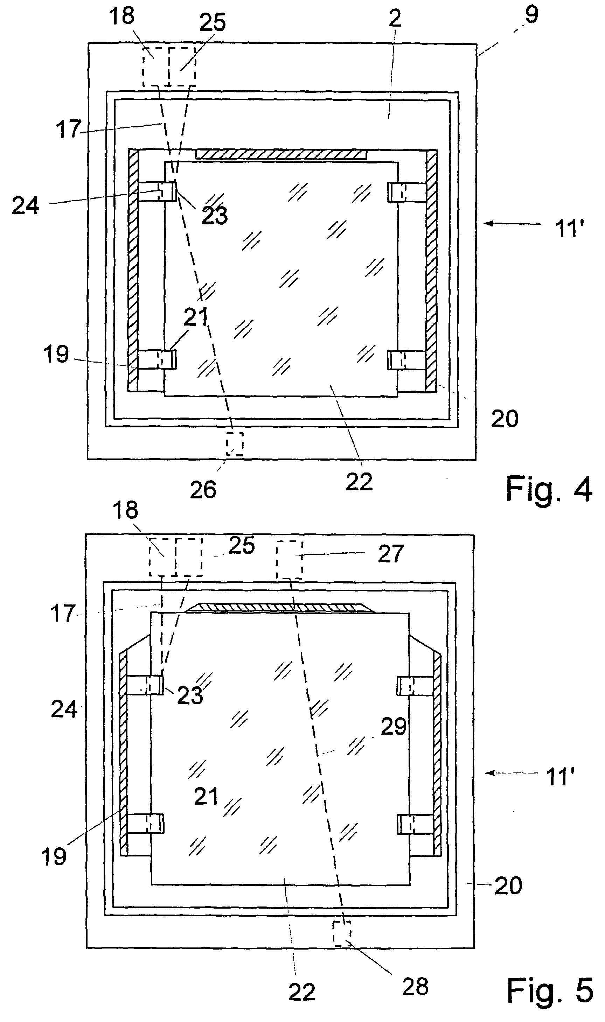

In Fällen, bei denen die zu detektierenden Objekte stirnseitig von Kante zu Kante transparent sind (Schablonen mit lichtdurchlässigen Seitenflächen), ist es zweckmäßig, gemäß den Figuren 4 und 5 das Meßstrahlenbündel 17 bzw. 29 in der Bezugsebene in einem spitzen Winkel geneigt zum senkrechten Strahlungseinfall auf die Schablone 22 und die Stege 21 zu richten.
Die Ausführung nach Fig. 4 sieht einen weiteren ortsempfindlich messenden Empfänger 26 an der gegenüberliegenden offenen Magazinseite vor. Hervorgerufen durch einen Planplatteneffekt wird in Abhängigkeit vom Brechungsindex das Meßstrahlenbündel 17 gegenüber seinem Eintritt in die Schablone 22 versetzt austreten, wenn sich eine Schablone 22 in einem Magazinfach befindet.
In der anordnungstechnisch günstigeren Variante ist der zusätzliche Empfänger 26 an dem Ort angeordnet, auf den das Meßstrahlenbündel trifft, wenn sich keine Schablone 22 im Magazinfach befindet. Befindet sich eine Schablone 22 im Magazinfach, empfängt der Empfänger 26 kein Signal.
Umgekehrt kann der weitere Empfänger natürlich auch an dem Ort vorgesehen werden, auf den das versetzte Meßstrahlenbündel fällt.

In Fig. 5 sind ein weiterer Sender 27 und ein weiterer Empfänger 28 mit einem zum senkrechten Strahlungseinfall geneigten Meßstrahlenbündel 29 vorgesehen. Die Funktionsweise entspricht der Anordnung gemäß Fig. 4 sinngemäß.
In beiden Fällen dient das Abstandsmeßsystem zur Erfassung der fächerbildenden Vorsprünge 21 und der weitere Empfänger 26 bzw. 28 zum Nachweis der Schablone 22.

Die Abstände der Magazinfächer von Schablonenmagazinen sind auf Grund ihres Herstellungsverfahrens nur mit kleinen Toleranzen behaftet. Diese Tatsache und der Umstand, daß in der Halbleiterfertigung häufig mit standardisierten Magazinen in einem Gerät gearbeitet wird, eröffnet die Möglichkeit, die Lage der Magazinfächer indirekt zu bestimmen und somit auch für ein leeres Magazin eine Unterscheidung des Magazinformates zu treffen.

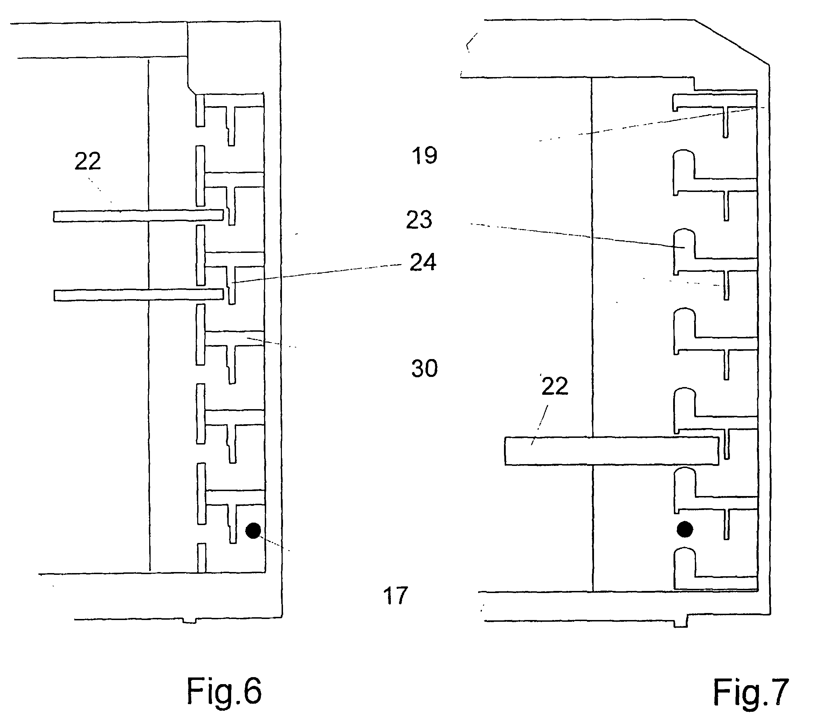

Die Figuren 6 bis 8 dienen der Erläuterung der Vorgehensweise zur Bestimmung des unterschiedlichen Magazinformates, wobei Fig. 6 ein 5" und Fig. 7 ein 6" Magazin zunächst einzeln dargestellt zeigen. Die Bezugszeichen entsprechen denen aus Fig. 3.

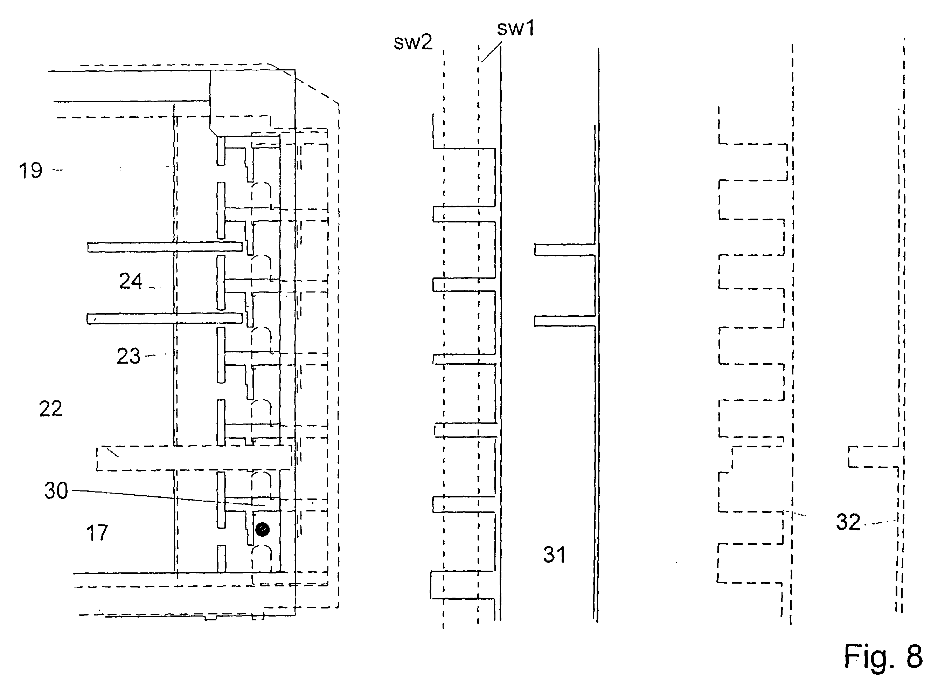

In Fig. 8 sind die beiden Magazine entsprechend ihrer Lage in einem Bearbeitungsgerät übereinanderprojiziert.
Bei ortsfester Sensoranordnung entsprechend Fig. 3 tastet das Meßstrahlenbündel 17 bei dem mit durchgehenden Linien dargestellten 5"-Schablonenmagazin infolge der Vertikalbewegung der Vorsprünge 21 Stege 30 und bei dem mit gestrichelten Linien dargestellten 6"-Schablonenmagazin die Auflagen 23 ab. Durch die feste geometrische Beziehung zwischen Auflage und Steg kann beim 5"-Schablonenmagazin auf den Ort der Auflage geschlossen werden.
Typische Signalverläufe, die bei der Abtastung entstehen, sind für das 5"-Schablonenmagazin mit 31 und für das 6"-Schablonenmagazin mit 32 bezeichnet.

Infolge der Vertikalbewegung des Magazins erfolgt eine Abrasterung durch das Meßstrahlenbündel 17, wobei der Analogwert des Sensorsignales und der zugehörige Wert der vertikalen Position, der sich über den Positionsregler des
Magazinlifts bestimmt, abgespeichert wird. Zur Datenreduzierung können Schwellwerte sw1 und sw2 für das Analogsignal gesetzt werden.
Mit Hilfe eines wählbaren Korrekturwertes, der dem Abstand zwischen dem Steg 30 und der Auflage 23 entspricht, und der Verknüpfung der gespeicherten vertikalen Positionswerte mit den Schwellwerten kann die exakte Positionierung der Magazinfächer bzw. der Schablonen gegenüber der Handhabungsebene H-H erfolgen.

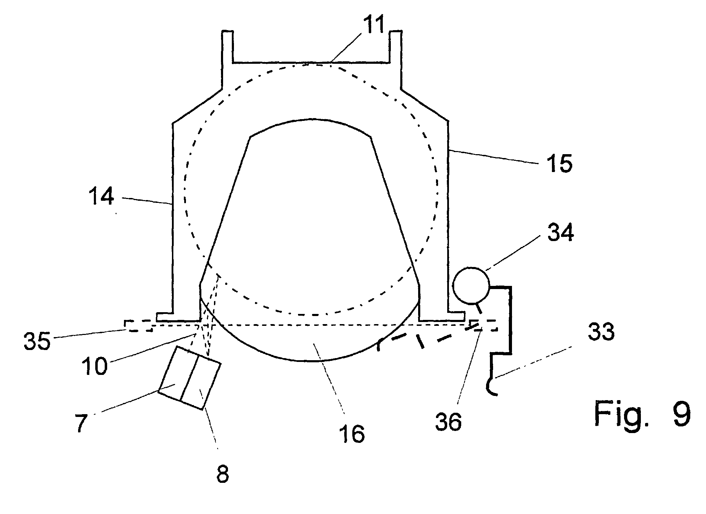

Wie anhand der Fig. 9 für ein Halbleiterscheibenmagazin deutlich wird, ist die Verwendung eines Abstandsmeßsystems auch dazu geeignet, die Korrektheit der Lage von scheibenförmigen Objekten, die stirnseitig von Kante zu Kante lichtundurchlässig sind, anhand der durch den Abstand bestimmten Größe des Analogsignales in jeder Ebene parallel zur Bezugsebene zu prüfen.

Liegt keine korrekte Ablage vor, dient eine Rückführeinrichtung 33 in einer zur ersten Handhabungsebene E-E parallelen zweiten Handhabungsebene dazu, herausragende Halbleiterscheiben 16 in das Magazin zurückzuschieben.
Damit kann der Transport des Magazins 11 ungestört ohne einen manuellen Eingriff fortgeführt werden.
Die Rückführeinrichtung 33 besteht aus einem elektromotorisch angetriebenen Hebelmechanismus 34, der bei einer Umdrehung seines Antriebs (nicht dargestellt) eine Schwenkbewegung von 90° ausführt. Der Umkehrpunkt des Hebels des Mechanismus 34 ist so angeordnet, daß er die Halbleiterscheibe 16 in das Magazin 11 schiebt und sich anschließend in eine Ausgangslage zurück begibt, die mit einem Endschalter überwacht wird.
Bei vorhandener Lichtdurchlässigkeit des Objektes von Kante zu Kante kann ein weiterer, gestrichelt dargestellter Sensor, bestehend aus einem Sender 35 und einem Empfänger 36, eingesetzt werden, dessen Sensorsignal das Wirksamwerden der Rückführeinrichtung 33 bestimmt.
In analoger Weise ist eine Rückführeinrichtung bei Scheibenmagazinen verwendbar.

Zur Ausführung der Erfindung sind der Schrittmotor 3, das Winkelmeßsystem 4, die Sender 7, 18, 27 und 35, die Empfänger 8, 25, 26, 28 und 36, ein weiterer, mit dem Rahmen 9 fest verbundener Sensor 37, der Hebelmechanismus 33 und der Endschalter mit einem Steuerrechner verknüpft. Zwischen die Sensoren und den Steuerrechner sind AD-Wandler geschaltet.

Nachdem die Magazinaufnahme 2 gegenüber dem weiteren Sensor 37, der einen bekannten Abstand zur Handhabungsebene H-H und zur Bezugsebene E-E besitzt, positioniert und der Zähler des Winkelmeßsystems genullt wurde, wird zur Indexierung der Magazinfächer und der darin befindlichen scheibenförmigen Objekte 12, 22 das Magazin 11 aus einem nicht dargestellten staubschützenden Transportbehälter mit dessen Boden automatisch entnommen und von der Magazinaufnahme 2 übernommen. Danach wird die Magazinaufnahme 2 abgesenkt, also in negative z-Richtung gefahren, bis ein Schwellwert sw2 von vorteilhafterweise zur Datenreduzierung festgelegten Schwellwerten sw1 und sw2 überschritten wird. Damit ist vom Magazin 11 der Abstand seines Bodens zur Bezugsebene E-E erfaßt.
Bei der Bewegung des Magazins 11 in Richtung seiner übereinanderliegenden Magazinfächer durch die Bezugsebene E-E erhält man ein amplitudenmoduliertes Sensorausgangssignal als Funktion des Weges an den Empfängern 8, 25, 26 bzw. 28, das das Abbild der Magazinfächer und der Objekte 12, 22 widerspiegelt bzw. aus dem das Abbild durch Berücksichtigung feststehender geometrischer Beziehungen erzeugt wird. Das Sensorausgangssignal wird in analog-digital gewandelter Form durch den Steuerrechner mit dem Meßsignal des Winkelmeßsystems 4 verknüpft und gespeichert.
Um ein Objekt 12, 22 aus dem Magazin 11 bzw. dem Scheibenmagazin zu entnehmen oder in einem leerem Magazinfach zu plazieren, wird zu dem ermittelten Zählerstand ein Wert für den Abstand zwischen der Bezugsebene E-E und der Handhabungsebene H-H addiert und das Magazin 11 bzw. das Scheibenmagazin mit Hilfe des Magazinlifts in die entsprechende z-Position gefahren.

## Patentansprüche

1. Indexer für Magazinfächer eines Magazins und darin enthaltene scheibenförmige Objekte, insbesondere Halbleiterscheiben und Schablonen, zu deren Bearbeitung das Magazin und eine erste Handhabungsebene zur Entnahme und Beschickung der Objekte im Magazin relativ zueinander vertikal verstellbar sind, mit einer optoelektronischen Sensoranordnung zum Erfassen der vertikalen Lage der Objekte im Magazin und der Magazinfächer relativ zu einer Bezugsebene, die mit der ersten Handhabungsebene in fester Beziehung steht und parallel zu dieser liegt, **dadurch gekennzeichnet,** daß die optoelektronische Sensoranordnung ein Abstandsmeßsystem zur Messung des Abstands der Sensoranordnung vom Rand der scheibenförmigen Objekte (12, 16, 22) sowie von fächerbildenden Vorsprüngen (13, 21) des Magazins (11, 11') aufweist.

2. Indexer nach Anspruch 1, dadurch gekennzeichnet, daß die als Abstandsmeßsystem ausgebildete Sensoranordnung an einer offenen Seite des Magazins (11, 11') angeordnet ist und einen Sender (7, 18) und einen Empfänger (8, 25) enthält, so daß ein von dem Sender (7, 18) ausgehendes, mit seinem Mittenstrahl in der Bezugsebene (E-E) liegendes Meßstrahlenbündel (10, 17) durch die Vertikalverstellung des Magazins (11, 11') relativ zur Bezugsebene (E-E) nacheinander die scheibenförmigen Objekte (12, 16, 22) und fächerbildende Vorsprünge (13, 21) erfaßt, wobei die Unterscheidung zwischen den Objekten (12, 16, 22) und den Vorsprüngen (13, 21) durch unterschiedliche Abstände zum Sender (7, 18) erfolgt.

3. Indexer nach Anspruch 1, dadurch gekennzeichnet, daß die optoelektronische Sensoranordnung aus einem Abstandsmeßsystem, das an einer offenen Seite des Magazins (11') in der Bezugsebene (E-E) angeordnet ist und einen Sender (18) und einen Empfänger (25) enthält, und einem an der gegenüberliegenden offenen Seite des Magazins (11') angeordneten weiteren Empfänger (26) besteht, wobei das Abstandsmeßsystem zur Erfassung des Abstandes zu den fächerbildenden Vorsprüngen (21) und der weitere Empfänger (26) zum Nachweis vorhandener Objekte (22) dienen.

4. Indexer nach Anspruch 3, dadurch gekennzeichnet, daß ein von dem Sender (18) ausgehendes Meßstrahlenbündel (17) in der Bezugsebene (E-E) zum senkrechten Strahlungseinfall auf die Objekte (22) und Vorsprünge (21) geneigt ist.

5. Indexer nach Anspruch 1, dadurch gekennzeichnet, daß die optoelektronische Sensoranordnung aus einem Abstandsmeßsystem, das an einer offenen Seite des Magazins (11') angeordnet, einen Sender (18) und einen Empfänger (25) enthält, einem weiteren Sender (27) auf derselben Seite und einem an der gegenüberliegenden offenen Seite des Magazins (11')angeordneten weiteren Empfänger (28) besteht, wobei das Abstandsmeßsystem zur Erfassung fächerbildender Vorsprünge (21) und der weitere Empfänger (28) zum Nachweis vorhandener Objekte (22) dienen.

6. Indexer nach Anspruch 5, dadurch gekennzeichnet, daß ein von dem weiteren Sender (27) ausgehendes Meßstrahlenbündel (29) in der Bezugsebene (E-E) zum senkrechten Strahlungseinfall auf die Objekte (22) geneigt ist.

7. Indexer nach Anspruch 4 oder 6, dadurch gekennzeichnet, daß der weitere Empfänger (26, 28) zur Erfassung des bei nicht vorhandenem Objekt (22) unverändert geradlinig durch das Magazin (11') verlaufenden Meßstrahlenbündels (17, 29) vorgesehen ist.

8. Indexer nach Anspruch 4 oder 6, dadurch gekennzeichnet, daß der weitere Empfänger (26, 28) zur Erfassung des Meßstrahlenbündels (17, 29) vorgesehen ist, das durch einen Planplatteneffekt eines vorhandenen, stimseitig von Kante zu Kante lichtdurchlässigen Objektes (22) versetzt wird.

9. Indexer nach einem der Ansprüche 1 bis 8, dadurch gekennzeichnet, daß der Sender (7, 18) und der Empfänger (8, 25) des Abstandsmeßsystems in einer Baueinheit zusammengefaßt sind.

10. Indexer nach einem der Ansprüche 1 bis 9, dadurch gekennzeichnet, daß zur Positionierung aus dem Magazin (11, 11') herausragender scheibenförmiger Objekte (12, 16, 22) eine Rückführeinrichtung (33) in einer zweiten Handhabungsebene parallel zur ersten Handhabungsebene (H-H) vorgesehen ist, deren Wirksamwerden bei scheibenförmigen Objekten (12, 16, 22), die stirnseitig von Kante zu Kante lichtundurchlässig sind, an die Größe des Sensorsignals des Abstandsmeßsystems gebunden ist.

## Claims

1. Indexer for magazine compartments of a magazine and disc-shaped objects contained therein, particularly semiconductor wafers and templates, for the processing of which the magazine and a first handling plane are vertically movable with respect to one another for the purpose of removal and loading of the objects in the magazine, including an optoelectronic sensor arrangement for detecting the vertical position of the objects in the magazine and of the magazine compartments relative to a reference plane, which is in a fixed relationship with the first handling plane and extends parallel to it, characterised in that the optoelectronic sensor arrangement has a distance measuring system for measuring the distance of the sensor arrangement from the edge of the disc-shaped objects (12,16,22) and from compartment-defining projections (13,21) on the magazine (11,11').

2. Indexer as claimed in claim 1, characterised in that the sensor arrangement, which is constructed as a distance measuring system, is arranged on an open side of the magazine (11,11') and includes a transmitter (7,18) and a receiver (8,25) so that a measuring radiation beam (10,17) emanating from the transmitter (7,18), with its central beam lying in the reference plane (E-E) detects the disc-shaped objects (12,16,22) and the compartment-defining projections (13,21) successively as a result of the vertical movement of the magazine (11,11') relative to the reference plane (E-E), whereby the differentiation between the objects (12,16,22) and the projections (13,21) is effected by different distances from the transmitter (7,18).

3. Indexer as claimed in claim 1, characterised in that the optoelectronic sensor arrangement comprises a distance measuring system, which is arranged on an open side of the magazine (11') in the reference plane (E-E) and includes a transmitter (18) and a receiver (25), and a further receiver (26) arranged on the opposite open side of the magazine (11'), whereby the distance measuring system server to detect the distance to the compartment-defining projections (21) and the further receiver (28) serves to detect objects (22) which are present.

4. Indexer as claimed in claim 3, characterised in that a measuring radiation beam (17) emanating from the transmitter (18) is inclined in the reference plane (E-E) to the vertical radiation incidence onto the objects (22) and projections (21).

5. Indexer as claimed in claim 1, characterised in that the optoelectronic sensor arrangement comprises a distance measuring system, which includes a transmitter (18) and a receiver (25) arranged on an open side of the magazine (11'), a further transmitter (27) on the same side and a further receiver (28) arranged on the opposite open side of the magazine (11'), whereby the distance measuring system serves to detect compartment-defining projections (21) and the further receiver (28) serves to detect objects (22) which are present.

6. Indexer as claimed in claim 5, characterised in that a measuring radiation beam (29), emanating from the further transmitter (27) is inclined in the reference plane (E-E) to the vertical radiation incidence onto the objects (22).

7. Indexer as claimed in claim 4 or 6, characterised in that the further receiver (26,28) is provided to detect the measuring radiation beam (17,29), which passes unaltered in a straight line through the magazine (11'), when no object (22) is present.

8. Indexer as claimed in claim 4 or 6, characterised in that the further receiver (26,28) is provided for detecting the measuring radiation beam (17,29), which is offset by a flat plate effect of an object (22) which is present and translucent at the end from edge to edge.

9. Indexer as claimed in one of claims 1 to 8, characterised in that the transmitter (7,18) and the receiver (8,25) of the distance measuring system are combined into a unit.

10. Indexer as claimed in one of claims 1 to 9, characterised in that for the purpose of positioning disc-shaped objects (12,16,22,) projecting out of the magazine (11,11'), a return device (33) is provided in a second handling plane parallel to the first handling plane (H-H), the operation of which with disc-shaped objects (12,16,22), which are opaque at the end from edge to edge, is associated with the magnitude of the sensor signal from the distance measuring system.

## Revendications

1. Dispositif d'indexation pour cases d'un magasin et objets en forme de disque contenus à l'intérieur, en particulier des pastilles de semiconducteurs et des gabarits, pour l'usinage desquels le magasin et un premier plan de manipulation, pour le prélèvement et le chargement des objets dans le magasin, doivent pouvoir être déplacés verticalement l'un par rapport à l'autre, comportant un dispositif optoélectronique à capteur pour détecter la position verticale des objets dans le magasin et des cases du magasin par rapport à un plan de référence qui se trouve dans une relation fixe avec le premier plan de manipulation et qui s'étend parallèlement à celui-ci, caractérisé en ce que le dispositif optoélectronique à capteur comporte un système de mesure de distance pour la mesure de la distance du dispositif à capteur par rapport au bord des objets (12, 16, 22) en forme de pastilles ainsi que par rapport à des saillies (13, 21) formant les cases du magasin (11, 11').

2. Dispositif d'indexation selon la revendication 1, caractérisé en ce que le dispositif à capteur, conformé en système de mesure de distance, est disposé sur un côté ouvert du magasin (11, 11') et contient un émetteur (16, 18) ainsi qu'un récepteur (8, 25), ce qui fait qu'un faisceau de rayons de mesure (10, 17), partant de l'émetteur (7, 18) et situé, avec son rayon central, dans le plan de référence (E-E), du fait de la position verticale du magasin (11, 11') par rapport au plan de référence (E-E), balaie l'un après l'autre les objets (12, 16, 22) en forme de pastilles et les saillies (13, 21) formant les cases, la distinction entre les objets (12, 16, 22) et les saillies (13, 21) se faisant par des distances différentes par rapport à l'émetteur (7, 18).

3. Dispositif d'indexation selon la revendication 1, caractérisé en ce que le dispositif optoélectronique à capteur est constitué d'un système de mesure de distance, qui est disposé sur un côté ouvert du magasin (11') dans le plan de référence (E-E) et qui contient un émetteur (18) ainsi qu'un récepteur (25), et d'un autre récepteur (26), disposé sur le côté ouvert opposé du magasin (11'), le système de mesure de distance servant à détecter la distance par rapport aux saillies (21) formant les cases et l'autre récepteur (26), servant à attester la présence d'objets (22).

4. Dispositif d'indexation selon la revendication 3, caractérisé en ce qu'un faisceau de rayons de mesure (17), partant de l'émetteur (18), est incliné dans le plan de référence (E-E) par rapport au rayonnement incident vertical sur les objets (22) et les saillies (21).

5. Dispositif d'indexation selon la revendication 1, caractérisé en ce que le dispositif optoélectronique à capteur est constitué d'un système de mesure de distance, qui est disposé sur un côté ouvert du magasin (11') et contient un émetteur (18) ainsi qu'un récepteur (25), d'un autre émetteur (27), sur le même côté et d'un autre récepteur (28), disposé sur le côté ouvert opposé du magasin (11'), le système de mesure de distance servant à détecter les saillies (21) formant les cases, et l'autre récepteur (28) servant à attester la présence d'objets (22).

6. Dispositif d'indexation selon la revendication 5, caractérisé en ce qu'un faisceau de rayons de mesure (29), partant de l'autre émetteur (27), est incliné dans le plan de référence (E-E) par rapport au rayonnement incident vertical sur les objets (22).

7. Dispositif d'indexation selon la revendication 4 ou 6, caractérisé en ce que l'autre récepteur (26, 28) est prévu pour détecter le faisceau de rayons de mesure (17, 29) qui, en l'absence d'objets (22), s'étend sans changement en ligne droite à travers le magasin (11').

8. Dispositif d'indexation selon la revendication 4 ou 6, caractérisé en ce que l'autre récepteur (26, 28) est prévu pour détecter le faisceau de rayons de mesure (17, 19) qui est décalé par un effet de plaque plane d'un objet (22) présent, laissant passer la lumière frontalement d'un bord à l'autre.

9. Dispositif d'indexation selon l'une des revendications 1 à 8, caractérisé en ce que l'émetteur (7, 18) et le récepteur (8, 25) du système de mesure de distance sont réunis en un ensemble.

10. Dispositif d'indexation selon l'une des revendications 1 à 9, caractérisé en ce que pour le positionnement d'objets (12, 16, 22) en forme de pastilles, ressortant du magasin (11, 11'), il est prévu un dispositif de retour (33) dans un deuxième plan de manipulation parallèle au premier plan de manipulation (H-H), dont l'entrée en action en cas d'objets (12, 16, 22) en forme de pastilles, qui laissent passer la lumière frontalement d'un bord à l'autre, est liée à la grandeur du signal de capteur du système de mesure de distance.
